# EUROPEAN PATENT SPECIFICATION

(11) **EP 3 154 191 B1**
(45) Date of publication and mention of the grant of the patent: **30.12.2020**
(21) Application number: 15189081.1
(22) Date of filing: 09.10.2015
(51) Int. Cl.: H03K 21/38, H03B 5/36

(54) **DRIVE CIRCUIT FOR AN OSCILLATOR**
TREIBERSCHALTUNG FÜR EINEN OSZILLATOR
CIRCUIT D'ENTRAÎNEMENT POUR UN OSCILLATEUR

(43) Date of publication of application: 12.04.2017
(73) Proprietor: The Swatch Group Research and Development Ltd., 2074 Marin (CH)
(72) Inventor: Bracco, Massimiliano, 2525 Le Landeron (CH)
(74) Representative: ICB SA

(56) References cited:
- EP-A1- 1 184 966
- EP-A1- 1 753 136
- WO-A1-96/30996
- US-A1- 2010 188 057
- US-A1- 2010 321 124
- US-A1- 2012 267 359
- US-A1- 2013 135 057

## Description

### TECHNICAL FIELD

The invention relates to the field of drive circuits for driving an oscillator circuit, such as a crystal oscillator used in watches, for example. The invention also relates to an electronic circuit comprising the drive circuit and the oscillator and to a method for driving the oscillator.

### BACKGROUND OF THE INVENTION

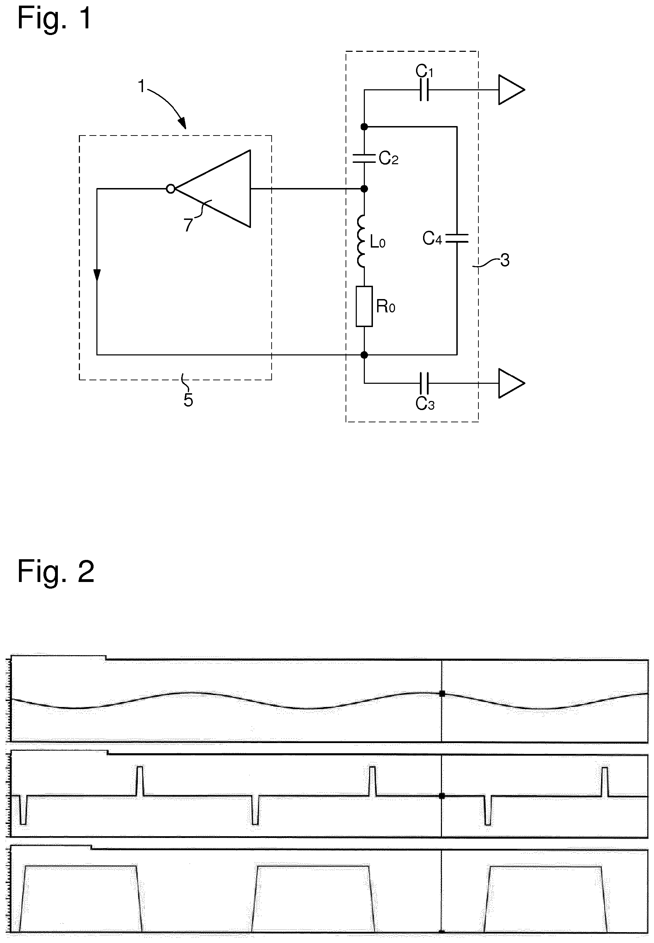

The circuit diagram of Figure 1 illustrates an electronic circuit 1 comprising a circuit 3 representing a crystal oscillator and a prior art drive circuit 5 for driving the crystal oscillator 3. As can be seen, the crystal oscillator is modelled by a first capacitor C₁, a second capacitor C₂, an oscillator inductor L_{O}, a resistor R_{O}, a third capacitor C₃ and a fourth capacitor C₄ connected in parallel with the second capacitor, the coil and the resistor. One of the electrodes of the first and third capacitors is connected to ground. In the circuit of Figure 1, the drive circuit is modelled by an inverter circuit 7. This kind of drive circuit is currently widely used to drive crystal oscillators, for example. The inverter circuit 7 may comprise at least an n-type metal-oxide-semiconductor (MOS) transistor and a p-type MOS transistor, for example. The crystal oscillator and the drive circuit are connected so as to form a positive feedback circuit, which induces an oscillation.

The signal diagram of Figure 2 illustrates the behaviour of the signals of the electronic circuit 1 of Figure 1. It is to be noted that, to better illustrate the results, the resistor R_{O} has been omitted. The first (top) graph illustrates the voltage of the second capacitor C₂ as a function of time. In other words this graph illustrates the oscillation of the crystal oscillator. The second graph illustrates the output current of the drive circuit over time, while the third graph shows the drive circuit output voltage. The drive circuit 5 of Figure 1 drives the crystal oscillator 3 for a full half-cycle of the oscillation. In the second graph in Figure 2, it can be seen that the current from the drive circuit flows in both directions during a semi-period of oscillation, which means that the energy in the oscillator inductor L_{O} of the crystal oscillator 3 is not increased and the voltage across the crystal oscillator does not increase. Assuming ideal conditions, i.e. no resistance and every component ideal, then the current provided by the drive circuit 5 must be dissipated in the drive circuit 5. In a real application this means that the energy is dissipated in the parasitic resistance of the transistors of the drive circuit 5.

Thus it becomes clear that the electronic circuit illustrated in Figure 1 is not optimal in terms of power consumption. More specifically, the current flow from the driver 5 is not in phase with the current flow of the crystal oscillator 3, and this causes power dissipation in the transistors of the driver 5. A further problem may arise due to the brief but significant current which may flow in the inverter 7 during each switching transition of the inverter 7. Such a transition current spike may arise if the inverter comprises an NMOS-PMOS transistor pair as mentioned above, where this pair effectively presents a short-circuit when both are momentarily on.

The patent application EP 1 184 966 A1 describes a high-voltage pulse generator. Said generator includes a switching field effect transistor to supply output pulses on the basis of a high-voltage source. It further includes two oscillator circuits, an inductor arranged between the voltage source and one of the oscillator circuits. No drive circuit is provided to drive a crystal oscillator with more energy efficient.

The patent application EP 1 753 136 A1 describes a radar oscillator to prevent leakage of an oscillating signal. There is a drive circuit for a resonator. An inductor is connected to a voltage source and to a switching circuit. No drive circuit is provided to drive a crystal oscillator with more energy efficient.

The patent application US 2010/0321124 A1 describes a resonator oscillator, which includes an inductor connected to a voltage source and to a switching circuit. The resonator is controlled via the switching circuit. No drive circuit is provided to drive a crystal oscillator with more energy efficient.

The patent application US 2013/0135057 A1 describes an electronic circuit with at least one inductor connected to a supply voltage and to a switching circuit, which is connected to an oscillator. No drive circuit is provided to drive a crystal oscillator with more energy efficient.

The patent application US 2012/0267359 A1 describes a circuit with an inductor connected to a supply voltage and to a switching circuit for controlling a power oscillator, which is a heating inductor. No drive circuit is provided to drive a crystal oscillator with more energy efficient.

### SUMMARY OF THE INVENTION

It is an object of the present invention to overcome the problems identified above related to oscillator drive circuits.

According to a first aspect of the invention, there is provided a drive circuit for driving an oscillator as recited in claim 1.

The proposed new solution has the advantage that the operation of the drive circuit is more energy efficient than the state of the art drive circuits for oscillators. This is achieved by avoiding short circuit current and by driving the oscillator in phase with the oscillations of the oscillator, as explained later more in detail.

According to a second aspect of the invention, there is provided an electronic circuit comprising the drive circuit and an oscillator driven by the drive circuit.

According to a third aspect of the invention, there is provided a method of driving the oscillator according to claim 12.

Other aspects of the invention are recited in the dependent claims attached hereto.

### BRIEF DESCRIPTION OF THE DRAWINGS

Other features and advantages of the invention will become apparent from the following description of a non-limiting exemplary embodiment, with reference to the appended drawings, in which :
Figure 1 is a circuit diagram illustrating a state of the art electronic circuit comprising a crystal oscillator and a drive circuit for driving the crystal oscillator;
Figure 2 is a signal diagram illustrating the behaviour of the signals in the electronic circuit of Figure 1;
Figure 3 is a circuit diagram illustrating an electronic circuit comprising a crystal oscillator and a drive circuit according to an embodiment of the present invention for driving the crystal oscillator; and
Figure 4 is a signal diagram illustrating the behaviour of the signals in the electronic circuit of Figure 3.

### DETAILED DESCRIPTION OF AN EMBODIMENT OF THE INVENTION

An embodiment of the present invention will now be described in detail with reference to the attached figures. The invention will be described in the context of a drive circuit for driving a crystal oscillator also known as a quartz of a watch. However, the disclosed drive circuit is not limited to be used in the context of crystal oscillators. Identical or corresponding functional and structural elements which appear in different drawings are assigned to the same reference numerals.

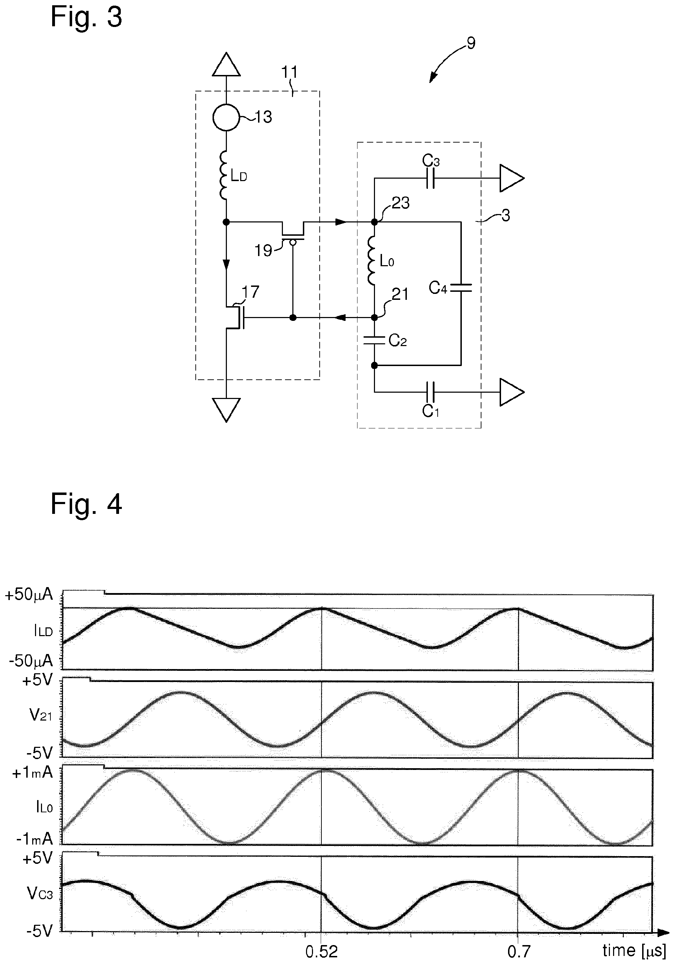

Figure 3 illustrates an electronic circuit 9 comprising a crystal oscillator 3, or more precisely a circuit representing the crystal oscillator 3, as in Figure 1. However, in the crystal oscillator of Figure 3, the resistor R_{O} has been omitted. As can be seen, the drive circuit 11 according to this embodiment differs from the drive circuit 5 of Figure 1. The drive circuit 11 comprises an electrical energy source 13, in this example a constant voltage source 13, connected between ground and a first terminal of a drive inductor L_{D}, also referred to as a first inductor. A second terminal of the drive inductor is connected to a switching circuit, which is also connected to the crystal oscillator 3 as shown in Figure 3. The switching circuit in this example comprises a first switch 17 and a second switch 19. In this illustrated example, the first switch is an NMOS transistor 17, while the second switch is a PMOS transistor 19.

As can be seen in Figure 3, the drain terminal of the NMOS transistor 17 is connected to the second terminal of the drive inductor L_{D}, while the source terminal of the NMOS transistor 17 is connected to ground. The gate of the NMOS transistor is connected to the crystal oscillator 3, and more particularly to a first node 21 located between the oscillator inductor L_{O}, also referred to as a second inductor, and the second capacitor C₂. The source of the PMOS transistor is connected to the second terminal of the drive inductor L_{D} while the drain of the PMOS transistor 19 is connected to the crystal oscillator 3 and more specifically to a second node 23 located between the oscillator inductor L_{O} and the third capacitor C₃. The gate of the PMOS transistor is connected to the first node 21.

In the present description, the NMOS transistor 17 is on (i.e. the channel from drain to source is conductive), when its gate-source voltage is positive, and more specifically with its gate voltage above a first threshold value, such as 0.5 V from the ground. In the present description, the PMOS transistor 19 on the other hand is on (i.e. the channel from source to drain is conductive) when its source-gate voltage is close to or greater than a second threshold of about 0.6 V. In this particular case, the second threshold value is greater than the first threshold value. This means that during a short time period the NMOS and PMOS transistors may both be conductive.

Next, the operation of the electronic circuit 9 is explained in more detail. In an initial state, when no electrical energy is supplied to the crystal oscillator 3, the capacitors of the crystal oscillator 3 are discharged and no current flows in the crystal oscillator. At this stage the gate voltages of the NMOS and PMOS transistors 17, 19 are 0 V and only the PMOS transistor is conductive. In other words the switching circuit is in an on state. When the voltage source 13 is turned on, current starts to flow through the drive inductor L_{D} and through the conductive source-drain channel of the PMOS transistor 19 to the crystal oscillator 3. At this point, current starts to flow in the crystal oscillator 3, and the capacitors C₁, C₂, C₃, C₄ start to charge. At the same time, the gate voltages of the NMOS and PMOS transistors 17, 19 start to rise. This also means that the PMOS transistor 19 turns off as the NMOS transistor 17 turns on, with the result that the current no longer flows to the crystal oscillator 3, but flows instead through the conductive drain-source channel of the NMOS transistor 17 to ground. In this state, the switching circuit is in an off state. When the NMOS transistor 17 is on, the current flowing through the drive inductor L_{D} stores energy temporarily in a magnetic field, for example in its coil. The drive inductor L_{D} is therefore in a charging or energising state.

The crystal oscillator has thus now started to oscillate, thanks to the energy provided to it at the beginning. This means that NMOS transistor 17 turns off again, while the PMOS transistor 19 turns on, and the magnetic field energy is delivered as additional current flowing through the PMOS transistor 19 to the second node 23 in the crystal oscillator 3 to charge the capacitors in the crystal oscillator. In other words, at this point, the energy stored in the magnetic field "pushes" current from the voltage source 13 to the crystal oscillator 3. Now, the drive inductor L_{D} is therefore in a discharging or de-energising state. The PMOS transistor 19 then turns off again, as the NMOS transistor 17 turns on. The operation explained above will then be repeated according to a given sequence while the crystal oscillator 3 continues to oscillate.

The signal diagram of Figure 4 illustrates the behaviour of the signals in the electronic circuit of Figure 3. The two vertical lines in the diagram of Figure 4 show the duration of a full signal cycle. The first (top) graph shows the variation of the current through the drive inductor L_{D}. The second graph from the top illustrates the variation of the crystal oscillator voltage, i.e. the electrical potential at the first node 21. The electrical potential measured at this node substantially corresponds also to the electrical potential at the gates of the first and second transistors 17, 19. The third graph from the top shows the current flow in the crystal oscillator 3, i.e. the magnitude of the current flowing through the oscillator inductor L_{O}. Finally, the last graph illustrates the voltage of the crystal oscillator, i.e. the voltage across the third capacitor C₃. It is to be noted that the numerical values in Figure 4 are merely exemplary and ignore the resistance in the crystal oscillator 3. The voltage maintained by the constant voltage source 13 is about 3 V in this example.

In view of the explanation above, the operation of the NMOS and PMOS transistors can be approximated by stating that the NMOS transistor 17 is on and the PMOS transistor 19 is off during a positive half-cycle of the crystal oscillator voltage (second graph from the top in Figure 4); whereas the NMOS transistor 17 is off and the PMOS transistor 19 is on during a negative half-cycle of the crystal oscillator voltage. Thus, during a positive half-cycle of the crystal oscillator voltage, the magnetic field energy increases, and when the crystal oscillator voltage becomes negative (second graph in Figure 4), the charge is pushed by the magnetic field of the drive inductor L_{D} into the third capacitor C₃ (last graph in Figure 4), thereby helping the oscillator inductor L_{O} to increase its voltage again (second graph in Figure 4).

As has been explained above, according to the present invention energy is temporarily stored in the drive inductor L_{D}. In this way, the short circuit current which occurs in the prior art drive circuits can be avoided, because the energy is stored in the drive inductor L_{D} instead of being shorted to ground. Furthermore, the electrical energy from the voltage source 13 is injected to the crystal oscillator 3 synchronously (i.e. in phase) with the oscillations of the crystal oscillator, with the help of the energy stored in the drive inductor L_{D}. This means that the electrical energy is provided to the crystal oscillator 3 only at given time instants, and more particularly when the electrical potential at the first node 21 is below the second threshold value. Thus, according to the present invention, the crystal oscillator 3 is fed with the current from the drive circuit 11 only when the crystal oscillator is ready to receive this current. In other words, according to the present invention the drive circuit 11 is in phase with the crystal oscillator 3 and the crystal oscillator 3 is not driven against the current flow of the crystal oscillator 3. It is to be noted that the feed inductance, together with the oscillation frequency and the voltage of the constant voltage source 13 determine the amount of energy delivered to the oscillator 3 on each cycle. Thus, the value of the feed inductance may need to be tuned to the frequency, or to the particular oscillator.

The present invention also relates to a method of driving the crystal oscillator 3 by supplying electrical energy from an electrical energy source 13 to the oscillator 3 via the drive inductor L_{D} such that the drive inductor L_{D} is energised by the electrical energy source 13 during a first phase of the oscillator cycle, during which the oscillator 3 is in a non-receptive state, and such that at least some of the energy stored in the drive inductor L_{D} during the first phase is used to transfer electrical energy from the electrical energy source 13 to the oscillator 3 during a second phase of the oscillator cycle, during which the oscillator is in an energy-receptive state.

While the invention has been illustrated and described in detail in the drawings and foregoing description, such illustration and description are to be considered illustrative or exemplary and not restrictive, the invention being not limited to the disclosed embodiment. Other embodiments and variants are understood, and can be achieved by those skilled in the art when carrying out the claimed invention, based on a study of the drawings, the disclosure and the appended claims. For instance, the number of terminals of the transistors can be more than three. The number of terminals in some variants is four. Moreover, the drive circuit can comprise further circuit elements, such as a capacitor pre-charging circuit for charging the capacitors of the oscillator, a current limiter for limiting the currents in the electronic circuit 11 and/or a control circuit for controlling the switching of the switches 17, 19 of the drive circuit 11 for example.

In the claims, the word "comprising" does not exclude other elements or steps, and the indefinite article "a" or "an" does not exclude a plurality. The mere fact that different features are recited in mutually different dependent claims does not indicate that a combination of these features cannot be advantageously used. Any reference signs in the claims should not be construed as limiting the scope of the invention.

## Claims

1. Drive circuit (11) for driving a crystal oscillator (3) comprising a first (23) and a second (21) terminal, the drive circuit (11) comprising:
- a first inductor (L_{D}) comprising a first terminal and a second terminal;
- an electrical energy source (13) connected to the first terminal; and
- a switching circuit connected between the second terminal and the crystal oscillator (3), the switching circuit being configured to operate at least in an off state, in which it conveys substantially no electrical energy to the crystal oscillator (3), and in an on state, in which it conveys electrical energy to the crystal oscillator (3), said switching circuit including a first switch (17) and a second switch (19),
**characterized in that** the first inductor (L_{D}) is arranged to store energy in its magnetic field while the switching circuit is in the off state, and, when the switching circuit is in the on state, the switching circuit is arranged to use at least some of the energy stored in the magnetic field to deliver a surge of current from the electrical energy source (13) to the crystal oscillator (3),
**in that** the first switch is a first NMOS transistor (17) and the second switch is a second PMOS transistor (19), and
**in that** gate terminals of the first and second MOS transistors (17, 19) are connected to a common node connected to the second oscillator terminal (21), a drain of the first NMOS transistor (17) and a source of the second PMOS transistor (19) being connected to the second terminal of the first inductor (L_{D}), the drain of the second PMOS transistor being connected to the first oscillator terminal, and wherein the switching circuit is configured to be in the off state when the electrical potential at the common node (21) is greater than a first threshold value, and in the on state when an electrical difference potential between the second terminal and the common node (21) is above a second threshold value.

2. Drive circuit (11) according to claim 1, **characterized in that** the second threshold value is higher than the first threshold value.

3. Drive circuit (11) according to claim 1, **characterized in that** the first and second threshold values are positive voltages.

4. Drive circuit (11) according to any one of claims 2 and 3, **characterized in that** the first and second threshold values are between 0 V and 1 V.

5. Drive circuit (11) according to claim 1, **characterized in that** a source terminal of the first transistor (17) is connected to ground, while a drain terminal of the first transistor (17) is connected to the second terminal.

6. Drive circuit (11) according to claim 1, **characterized in that** a source terminal of the second transistor (19) is connected to the second terminal.

7. Drive circuit (11) according to any one of the preceding claims, **characterized in that** the electrical energy source (13) comprises a constant voltage source.

8. Electronic circuit (9) comprising the drive circuit (11) according to any one of the preceding claims and the crystal oscillator (3).

9. Electronic circuit (9) according to claim 8, **characterized in that** the oscillator (3) comprises a second inductor (L_{O}) comprising a third terminal (23) and a fourth terminal (21), and a capacitor (C₂) connected in series with the second inductor (L_{O}), and **in that** a drain terminal of the second PMOS transistor (19) is connected to the third terminal (23).

10. Electronic circuit (9) according to claim 9, **characterized in that** gate terminals of the first and second transistors (17, 19) are connected to the fourth terminal (21).

11. Electronic circuit (9) according to any one of claims 8 to 10, **characterized in that** the operation of the switching circuit is configured to be controlled by the electrical potential at the fourth terminal (21).

12. Method of driving a crystal oscillator (3) by the drive circuit (11) according to claim 1, by supplying electrical energy from an electrical energy source (13) to the crystal oscillator (3) via the first inductor (L_{D}) such that said inductor (L_{D}) is energised by the electrical energy source (13) during a first phase of the oscillator cycle, during which the crystal oscillator (3) is in a non-receptive state, and such that at least some of the energy stored in said inductor (L_{D}) during the first phase is used to deliver a surge of current from the electrical energy source (13) to the crystal oscillator (3) during a second phase of the oscillator cycle, during which the oscillator is in an energy-receptive state.

## Patentansprüche

1. Antriebsschaltung (11) für den Antrieb eines Kristalloszillators (3), umfassend eine erste (23) und eine zweite (21) Klemme, wobei die Antriebsschaltung (11) umfasst:
- einen ersten Induktor (L_{D}), umfassend eine erste Klemme und eine zweite Klemme;
- eine elektrische Energiequelle (13), die an die erste Klemme angeschlossen ist; und
- einen Schaltkreis, der zwischen der zweiten Klemme und dem Kristalloszillator (3) angeschlossen ist, wobei der Schaltkreis konfiguriert ist, mindestens in einem Aus-Zustand zu funktionieren, in dem er im Wesentlichen keine elektrische Energie an den Kristalloszillator (3) liefert, und in einem Ein-Zustand, in dem er elektrische Energie an den Kristalloszillator (3) liefert, wobei der Schaltkreis einen ersten Schalter (17) und einen zweiten Schalter (19) umfasst,
**dadurch gekennzeichnet, dass** der erste Induktor (L_{D}) angeordnet ist, um Energie in seinem Magnetfeld zu speichern, während sich der Schaltkreis im Aus-Zustand befindet, und, wenn sich der Schaltkreis im Ein-Zustand befindet, der Schaltkreis angeordnet ist, um mindestens etwas von der Energie, die in dem Magnetfeld gespeichert ist, zu verwenden, um einen Stromstoß von der elektrischen Energiequelle (13) an den Kristalloszillator (3) zu senden,
dadurch, dass der erste Schalter ein erster NMOS-Transistor (17) ist und der zweite Schalter ein zweiter PMOS-Transistor (19) ist und
dadurch, dass Gate-Klemmen des ersten und zweiten MOS-Transistors (17, 19) an einen gemeinsamen Knoten angeschlossen sind, der an die zweite Oszillatorklemme (21) angeschlossen ist, wobei ein Drain-Anschluss des ersten NMOS-Transistors (17) und ein Source-Anschluss des zweiten PMOS-Transistors (19) an die zweite Klemme des ersten Induktors (L_{D}) angeschlossen sind, wobei der Drain-Anschluss des zweiten PMOS-Transistors an die erste Oszillatorklemme angeschlossen ist, und wobei der Schaltkreis konfiguriert ist, sich im Aus-Zustand zu befinden, wenn das elektrische Potential des gemeinsamen Knotens (21) größer ist als ein erster Grenzwert, und sich im Ein-Zustand zu befinden, wenn ein elektrisches Differenzpotential zwischen der zweiten Klemme und dem gemeinsamen Knoten (21) über einem zweiten Grenzwert liegt.

2. Antriebsschaltung (11) nach Anspruch 1, **dadurch gekennzeichnet, dass** der zweite Grenzwert höher ist als der erste Grenzwert.

3. Antriebsschaltung (11) nach Anspruch 1, **dadurch gekennzeichnet, dass** der erste und zweite Grenzwert positive Spannungen sind.

4. Antriebsschaltung (11) nach einem der Ansprüche 2 und 3, **dadurch gekennzeichnet, dass** der erste und zweite Grenzwert zwischen 0 V und 1 V liegen.

5. Antriebsschaltung (11) nach Anspruch 1, **dadurch gekennzeichnet, dass** eine Source-Klemme des ersten Transistors (17) an die Erdung angeschlossen ist, während eine Drain-Klemme des ersten Transistors (17) an die zweite Klemme angeschlossen ist.

6. Antriebsschaltung (11) nach Anspruch 1, **dadurch gekennzeichnet, dass** eine Source-Klemme des zweiten Transistors (19) an die zweite Klemme angeschlossen ist.

7. Antriebsschaltung (11) nach einem der vorstehenden Ansprüche, **dadurch gekennzeichnet, dass** die elektrische Energiequelle (13) eine konstante Spannungsquelle umfasst.

8. Elektronische Schaltung (9), umfassend die Antriebsschaltung (11) nach einem der vorstehenden Ansprüche und den Kristalloszillator (3).

9. Elektronische Schaltung (9) nach Anspruch 8, **dadurch gekennzeichnet, dass** der Oszillator (3) einen zweiten Induktor (L_{O}), umfassend eine dritte Klemme (23) und eine vierte Klemme (21), und einen Kondensator (C₂) umfasst, der in Serie mit dem zweiten Induktor (L_{O}) angeschlossen ist, und dadurch, dass eine Drain-Klemme des zweiten PMOS-Transistors (19) an die dritte Klemme (23) angeschlossen ist.

10. Elektronische Schaltung (9) nach Anspruch 9, **dadurch gekennzeichnet, dass** Gate-Klemmen des ersten und zweiten Transistors (17, 19) an die vierte Klemme (21) angeschlossen sind.

11. Elektronische Schaltung (9) nach einem der Ansprüche 8 bis 10, **dadurch gekennzeichnet, dass** der Betrieb des Schaltkreises so konfiguriert ist, dass er von dem elektrischen Potential an der vierten Klemme (21) gesteuert wird.

12. Verfahren für den Antrieb eines Kristalloszillators (3) durch die Antriebsschaltung (11) nach Anspruch 1, indem elektrische Energie von einer elektrischen Energiequelle (13) an den Kristalloszillator (3) über den ersten Induktor (L_{D}) geliefert wird, sodass der Induktor (L_{D}) von der elektrischen Energiequelle (13) während einer ersten Phase des Oszillatorzyklus angesteuert wird, während welcher sich der Kristalloszillator (3) in einem nicht-rezeptiven Zustand befindet, und sodass mindestens etwas von der Energie, die in dem Induktor (L_{D}) gespeichert ist, während der ersten Phase verwendet wird, um einen Stromstoß von der elektrischen Energiequelle (13) an den Kristalloszillator (3) während einer zweiten Phase des Oszillatorzyklus zu senden, während welcher sich der Oszillator in einem energie-rezeptiven Zustand befindet.

## Revendications

1. Circuit d'entraînement (11) pour entraîner un oscillateur à quartz (3) comprenant une première borne (23) et une deuxième borne (21), le circuit d'entraînement (11) comprenant :
- un premier inducteur (L_{D}) comprenant une première borne et une deuxième borne ;
- une source d'énergie électrique (13) reliée à la première borne ; et
- un circuit de commutation relié entre la deuxième borne et l'oscillateur à quartz (3), le circuit de commutation étant configuré pour fonctionner au moins dans un état hors tension, dans lequel il ne transporte sensiblement pas d'énergie électrique jusqu'à l'oscillateur à quartz (3), et dans un état sous tension, dans lequel il transporte une énergie électrique jusqu'à l'oscillateur à quartz (3), ledit circuit de commutation incluant un premier commutateur (17) et un deuxième commutateur (19),
**caractérisé en ce que** le premier inducteur (L_{D}) est agencé pour stocker de l'énergie dans son champ magnétique pendant que le circuit de commutation est dans l'état hors tension, et, lorsque le circuit de commutation est dans l'état sous tension, le circuit de commutation est agencé pour utiliser au moins une partie de l'énergie stockée dans le champ magnétique pour apporter une surtension de courant de la source d'énergie électrique (13) à l'oscillateur à quartz (3),
**en ce que** le premier commutateur est un premier transistor NMOS (17) et le deuxième commutateur est un deuxième transistor PMOS (19), et
**en ce que** des bornes de grille des premier et deuxième transistors MOS (17, 19) sont reliées à un nœud commun relié à la deuxième borne d'oscillateur (21), un drain du premier transistor NMOS (17) et une source du deuxième transistor PMOS (19) étant reliés à la deuxième borne du premier inducteur (L_{D}), le drain du deuxième transistor PMOS étant relié à la première borne d'oscillateur, et
dans lequel le circuit de commutation est configuré pour être dans l'état hors tension lorsque le potentiel électrique au nœud commun (21) est supérieur à une première valeur de seuil, et dans l'état sous tension lorsqu'un potentiel de différence électrique entre la deuxième borne et le nœud commun (21) est supérieur à une deuxième valeur de seuil.

2. Circuit d'entraînement (11) selon la revendication 1, **caractérisé en ce que** la deuxième valeur de seuil est supérieure à la première valeur de seuil.

3. Circuit d'entraînement (11) selon la revendication 1, **caractérisé en ce que** les première et deuxième valeurs de seuil sont des tensions positives.

4. Circuit d'entraînement (11) selon l'une quelconque des revendications 2 et 3, **caractérisé en ce que** les première et deuxième valeurs de seuil sont entre 0 V et 1 V.

5. Circuit d'entraînement (11) selon la revendication 1, **caractérisé en ce qu'**une borne de source du premier transistor (17) est reliée à une masse, pendant qu'une borne de drain du premier transistor (17) est reliée à la deuxième borne.

6. Circuit d'entraînement (11) selon la revendication 1, **caractérisé en ce qu'**une borne de source du deuxième transistor (19) est reliée à la deuxième borne.

7. Circuit d'entraînement (11) selon l'une quelconque des revendications précédentes, **caractérisé en ce que** la source d'énergie électrique (13) comprend une source de tension constante.

8. Circuit électronique (9) comprenant le circuit d'entraînement (11) selon l'une quelconque des revendications précédentes et l'oscillateur à quartz (3).

9. Circuit électronique (9) selon la revendication 8, **caractérisé en ce que** l'oscillateur (3) comprend un deuxième inducteur (Lo) comprenant une troisième borne (23) et une quatrième borne (21), et un condensateur (C₂) relié en série au deuxième inducteur (L_{O}), et **en ce qu'**une borne de drain du deuxième transistor PMOS (19) est reliée à la troisième borne (23).

10. Circuit électronique (9) selon la revendication 9, **caractérisé en ce que** des bornes de grille des premier et deuxième transistors (17, 19) sont reliées à la quatrième borne (21).

11. Circuit électronique (9) selon l'une quelconque des revendications 8 à 10, **caractérisé en ce que** le fonctionnement du circuit de commutation est configuré pour être commandé par le potentiel électrique à la quatrième borne (21).

12. Procédé d'entraînement d'un oscillateur à quartz (3) par le circuit d'entraînement (11) selon la revendication 1, en fournissant une énergie électrique depuis une source d'énergie électrique (13) à l'oscillateur à quartz (3) via le premier inducteur (L_{D}) de sorte que ledit inducteur (L_{D}) est mis sous tension par la source d'énergie électrique (13) au cours d'une première phase du cycle d'oscillateur, pendant laquelle l'oscillateur à quartz (3) est dans un état de non-réception, et de sorte qu'au moins une partie de l'énergie stockée dans ledit inducteur (L_{D}) au cours de la première phase est utilisée pour apporter une surtension de courant de la source d'énergie électrique (13) à l'oscillateur à quartz (3) au cours d'une deuxième phase du cycle d'oscillateur, pendant laquelle l'oscillateur est dans un état de réception d'énergie.
